# EUROPEAN PATENT SPECIFICATION

(11) **EP 1 039 543 B1**
(45) Date of publication and mention of the grant of the patent: **26.02.2014**
(21) Application number: 00302389.2
(22) Date of filing: 23.03.2000
(51) Int. Cl.: H01L 23/498, H01L 21/60, G06K 19/077

(54) **Circuit chip connector and method of connecting a circuit chip**
Schaltungschip-Verbinder und Verbindungsmethode eines solchen
Connecteur d'une puce à circuit et methode de connexion de la meme associée

(30) Priority: 24.03.1999 US 125842 P; 18.08.1999 US 149486 P
(43) Date of publication of application: 27.09.2000
(73) Proprietor: Motorola Solutions, Inc., Schaumburg IL 60196 (US)
(72) Inventor: Pennaz, Thomas J., Champlin, Minnesota 55316 (US); Eberhardt, Noel H., Cupertino, CA 95014 (US)
(74) Representative: Treleven, Colin

(56) References cited:
- EP-A- 0 277 606
- DE-A- 19 716 342
- GB-A- 2 115 431
- US-A- 4 215 359
- US-A- 4 977 441
- US-A- 5 776 278
- "IMPROVED METHOD FOR C-4 CHIP JOIN" IBM TECHNICAL DISCLOSURE BULLETIN, IBM CORP. NEW YORK, US, vol. 31, no. 6, 1 November 1988 (1988-11-01), pages 335-336, XP000054208 ISSN: 0018-8689

## Description

This application has partial priority to U.S. Provisional Application Serial Number 60/125,842, filed March 24, 1999 and U.S. Provisional Application Serial Number 60/149,486, filed August 18, 1999.

### Background of the Invention

The present invention relates to a radio frequency identification device (RFID) tag and a method of making; a radio frequency device. More specifically, the invention is directed toward a method of mass-producingradio frequency identification tags (RFIDs), by mounting integrated circuit chips (ICs) on interposers that are then physically and electrically connected to the circuit, such as a conductive film antenna, using a pressure sensitive conductive adhesive.

Radio frequency (RF) devices such as RFIDs can be used for inventory management, highway toll express passes, and many other purposes that are suited for interrogation of the device. Such devices can be made by incorporating an appropriate IC across the gap of two conductive surfaces of a thin conductive film antenna. Such an antenna may be formed by introducing a gap between a conductive film surface, thus creating two conductive portions or halves. The IC contains encoded data for identification purposes. The IC and the antenna act together as a transponder, which receives an RF signal and modifies it according to the data encoded on the IC. An example of such RFID tags and their manufacture is given in US 5,776,278.

The invention is a RFID tag that includes a thin substrate, as an interposer, having two printed conductive ink pads. These pads provide a larger effective electrical contact area than ICs precisely aligned for direct placement without an interposer. The larger area reduces the accuracy required for placement of ICs during manufacture while still providing effective electrical connection. The substrate is coated with a pressure sensitive conductive adhesive that allows an IC to be electrically and mechanically mounted across the conductive ink pads. Pressure sensitive adhesives are preferred, but this production method is not limited only to pressure sensitive applications. The IC can be mounted across the gap of the interposer, ideally with the same adhesive as used to mount the interposer-IC subassembly to the circuit.

Methods are known in the art of connecting ICs to thin metallic foils, e.g., leadframes. In these methods, the IC is affixed on top of the leadframe, then the leadframe is connected to electrical connections on the IC by wire bonding techniques. Because of the fragile nature of the bonding, the connections are encapsulated for support. The present invention uses an interposer having conductive adhesive to both mechanically join and electrically connect the IC to a thin metallic film antenna, thus maintaining flexibility and providing a more robust connection. However, the scope of the present invention includes use in any thin film circuit application requiring placement of an IC or other flush mount components.

The prior art methods have difficulty in aligning ICs with base substrates or vice versa. IC placement was accomplished by first placing the individual base substrate in alignment with an IC, such that the bonding leads of the substrate are aligned to the connectors on the IC. Alternately, if the substrate is the base piece, the IC had to be precisely aligned for a physical and electrical connection. The relatively small bonding leads or pads on the substrate and IC provide a small effective connection area and greatly restrain the tolerances for placement of an IC across the gap of a thin metallic film circuit substrate. IC placement and mounting are serious limitations for high speed manufacturing.

A prior method of making a RF tag includes using a chip placement machine that mounts ICs between two separate conductive portions of a thin film antenna. This method requires the precise alignment of the IC between a gap of approximately 0.43mm (approximately 0.017 inch) between the antenna portions. Such tolerances greatly reduce line speeds. This method is acceptable for high-priced items that can be produced at slow line speed. The chip placement machine cannot be readily used for high speed application of ICs on low cost devices. Also, a chip placement machine is relatively costly to purchase and operate. The present invention with a pre-positioned IC overcomes this required precision so that a convertor, such as a label printer, can affix ICs with a high line speed as required for uses such as packaging or other disposable products incorporating RFID tags or similar devices. A converter can use existing technology to apply the IC mounted on an interposer without the need to purchase a chip placement machine.

Previous methods also required bonding such as thermosonic; lasersonic; soldering; or wire bonding. Such methods typically require more process steps and often have defects due to the application of heat in soldering or wire bonding. Further, wave soldering or reflow ovens often expose components to high temperatures that may cause damage to the components. These difficult methods are replaced in the present invention by applying an interposer of the present invention having a pre-positioned IC to the base substrate (i.e., antenna halves) with conductive adhesive. No heat needs to be applied in placing and connecting the interposer-chip subassembly to the substrate circuit. Heat and high humidity can be detrimental to chips. The pressure sensitive anisotropically conductive adhesive used in the present invention overcomes these bonding limitations and potential defect causing steps.

Current technology relies on the use of a conductive tape applied as a free film to attach the interposer to the RFID antenna or similar circuit. Significant flexibility, improved efficiency and lower cost are obtained by using a printable conductive adhesive. To form an aperture in a tape, a relatively difficult step of punching a hole is required. The adhesive of the present invention is printed over the conductor area and serves to attach the interposer to the antenna halves, both physically and electrically. It may be printed or applied in any pattern including having an aperture or recess.

Other techniques for bonding ICs to conductive circuit patterns of a substrate are known in the art, see for example US 4,215,359 which attaches an insulating foil incorporating conductors to a semiconductor element. Other methods uses an anisotropically conductive adhesive between raised areas (pads) for bonding on the substrate and matching bonding raised areas of the IC. The adhesive was typically an insulative polymer containing conductive particles that simultaneously contact a raised connection of the IC and a matching raised area of the substrate to provide interconnection. The conductive particles do not conduct in the lateral or horizontal direction since they transmit current only in the vertical direction between the substrate and device bonding raised areas. Such conduction is "anisotropic." The polymer is cured after mounting the IC on the substrate that thereafter provides a permanent structural bond in addition to a conductive connection. The replacement of solder bond connections by anisotropic conductive adhesives can often reduce assembly costs, can accommodate relatively high concentrations of conductive connections, and can make devices more amenable to repair and reconstruction. Similar techniques are needed to bond ICs to thin film circuit substrates, such as antenna halves, without significant curing times, without excessive heat, and without matching bonding raised areas in precise alignment. The present method uses pressure sensitive anisotropically conductive adhesive between the IC mounted on an interposer and the antenna halves (base substrate) to solve these concerns. Pressure sensitive adhesives are selected for ease of application, but other adhesives are available though not preferred.

Prior adhesives with conductive particles that simultaneously contact a raised connection of the IC and a matching raised area of the substrate to provide interconnection were not used with interposers and required precise alignment of the components and were only usable in one orientation. Also, many disposable substrates, such as thin polymeric films, cannot tolerate the high temperatures associated with curing.

The ICs were previously encapsulated by the application of a chip face encapsulant material on the ICs that are attached to the antenna. Typically, an epoxy was used. Besides long curing times, the use of epoxy may cause undesirable friction when joining circuits to an interposer. The present interposer can secure the IC, rather than placing an epoxy encapsulant over the surface of the IC. The curing of an epoxy encapsulant often takes hours and is not conducive to high speed production. The present invention overcomes the long cure time of such encapsulants by using a pressure sensitive conductive adhesive and an interposer that can secure the IC. Also, filled epoxy is more rigid so devices requiring flexibility are not well suited for epoxy encapsulants over the surface of the IC. The interposer of the present invention maintains flexibility.

ICs have become drastically less expensive, and are often not the most expensive part of a device. An IC may be incorporated into a device, such as an RFID tag, a luggage tag or prescription label, in which the device substrate would be the most expensive component. The "expensive device substrate," for lack of a better term, can be spoiled if the IC is not mounted correctly or if there is a short circuit in the mounted IC. Methods are known to check defective submodules, see for example DE 19716342 A1. Isolating the IC placement to the less expensive interposer subassembly allows IC defects to be detected before the final assembly to the more expensive device substrate, such as a thin film antenna. An IC on an interposer will make for less spoilage of the "expensive device substrate." Spoilage is limited to the lowest cost component when a low-cost interposer with an IC is used.

This relates to another critical problem overcome by the interposer-chip combination. Certain applications require sequential production of expensive device substrates, such as numbered pharmaceutical labels or packages. If a bad IC is inserted in such a sequence-critical application, the web would have to be re-spliced, effectively shutting down production until completed. By isolating the individual interposer-chip combination as a subassembly, the interposer can be applied by a standard head that can repeat without shutting down when a bad IC is detected so that there are no missing labels or packages in the sequence.

It has therefore been an aim of the invention to produce a RFID tag with an interposer that is inexpensive to mass produce and easy to insert at high line speed, preferably in multiple orientations with respect to the antenna or similar circuit. The present invention incorporates some of the advantages of the existing technology, while alleviating several of the problems associated therewith. Interposers are well suited for high volume applications because they offer low-cost solutions and easy attachment. It is a further aim to produce animproved method of manufacturing a thin RF transponder with such an interposer is necessary for such mass production.

### Summary of the Invention

It is a primary objective of the present invention to provide a RFID tag as characterised by claim 1 and a method for manufacturing RFID tags or labels in which ICs are attached to a RF antenna, or a similar circuit made from a metallized film substrate or other metallized flex circuit, by using an interposer subassembly having a preattached IC on a printed conductive pad and using an anisotropically conductive pressure sensitive adhesive.

RFIDs require an RF antenna and an appropriate IC encoded with data. The present invention uses an interposer having an IC as a subassembly that is attached to a thin conductive film antenna. An RF antenna is formed by creating a gap between two portions of metal on a thin metallic film. The gap may be formed by using a laser or by masking the gap before the metallic film is applied to the thin film. The IC via an interposer is connected across the gap between the antenna portions, thus creating an RFID. No wiring or heating is required because the interposer has two pads, such as carbon ink printed, that make electrical contact with the isolated antenna portions, via an electrically conductive adhesive. A pressure sensitive adhesive will not require significant curing time for attachment to become effective.

With the disclosed interposer, an IC is not directly mechanically and electrically attached to the antenna. The IC is attached to an interposer so that it can be positioned at the connection ends of the antenna circuit. The interposer comprises a base substrate film with two printed pads. An IC is connected between the two electrically isolated pads. The interposer can provide added structural support and can secure the internal components. Other flush mount components, such as light emitted diodes (LEDs), can be attached using similar techniques. This removes the limitations for precise placement on the leads of a circuit. Additionally, IC's can be mounted on conventional circuits via an interposer.

Placement of the IC is easier with the interposer. The gap between antenna portions is critical for proper functioning of an RF antenna. The antenna gap is dictated by the spacing between the IC pads and requires the IC to be precisely inserted (by machine placement for instance) between a space of 0.36 and 0.51mm (0.014 and 0.020 inch), which is a typical gap between IC pads. The interposer isolates the IC placement to this critical gap by limiting it to a subassembly having a critical gap created between two relatively large separate conductive interposer pads. The IC is placed across the critical gap between the interposer pads. Since the connector pads of the interposer can contact any portion of the antenna pad to establish electrical connection, placement of the interposer is not constrained by the relatively small critical interposer gap. However, the interposer pads still maintain an electrical connection across the noncritical antenna gap. This removes the IC placement constraint created by the critical antenna gap located on the antenna circuit substrate while maintaining the function of the critical gap in the circuit. The larger area of the interposer pads reduces the accuracy required for placement of ICs during manufacture while still providing effective electrical connection. This allows an IC to be placed across the gap with greater placement tolerances. An example of such an interposer pad would be a printed carbon ink that is 5.08mm (0.20 inches) extended from the IC connection area. Silver is an expensive substitute for carbon ink and the tolerance can dictate the necessary extension of the pad from the IC connection area. It is contemplated that the carbon ink or silver ink pad is not printed on the entire interposer surface.

With the present disclosure, insertion can be used with many devices. The interposer pattern or repeat is constant thereby simplifying the critical IC placement step. There is still a critical gap, but it is in a constant format. Variability of the antenna pattern adds significant complexity to the direct IC attachment process. For example, tickets, luggage tags, anti-theft devices or inventory control devices have different layouts for antennas or other circuits. Direct attachment would require a reconfiguration for each different antenna or circuit layout. By standardizing the IC placement via the interposer in a preferred embodiment, the finished part can vary widely and not encumber the process.

In a preferred embodiment disclosed herein, numerous interposer-chip subassemblies are prepared for subsequent attachment to antennas by starting with numerous printed interposers on a web to which a plurality of ICs is attached. Nearly 1000 interposers can be placed on each foot of web with a width of 0.45m (18 inches). Preferably, each interposer-chip subassembly is separate and rectangular for easy application like a label. The group of interposer-chip subassemblies is inexpensive to mass produce and easy to insert at high line speed with less spoilage of devices due to defective ICs. The interposers are designed for a minimum press speed of 80 feet per minute.

This invention also includes a geometry of components that allows for attachment of the interposer chip subcomponent regardless of the orientation of the antenna or similar circuit to which it is attached. Current IC mounting technology requires the IC be mounted across the interposer gap. Interposers are inserted in the web direction to be accurately placed on the antenna or similar circuit. The gap must presently be perpendicular to the interposer web direction due to IC orientation. Therefore, without the improved geometry, the interposer reel must be oriented parallel to the antenna web being printed.

Due to space limitation, press configuration, web optimization or other considerations, it may be desirable to orient the antenna gaps either parallel or perpendicular to the web direction during printing or application. In fact, in extreme cases, it may be desirable to orient the antenna gaps at angles other than 0° or 90° to the web, in which case, current geometries fail.

This limitation can be overcome through geometry that allows universal orientation of the antenna to the web and allows efficient interposer insertion regardless of antenna orientation. The improved geometry includes conductive ink pads that are in the shape of a butterfly, propeller or bow-tie pattern preferably with a separation line between each portion. The butterfly, propeller or bow-tie pattern extends from one corner of the label to the opposite corner. The pattern must maintain a gap perpendicular to the web to allow for IC placement across the gap. Preferably, a conductive adhesive is printed or applied around the edges of the label with a recess of no adhesive in the center.

It is also contemplated that a metallized film package can be used as an antenna for an RFID device. Metallized films and papers are common components of packaging and labels used for barrier properties, opacity, and desirable graphics. Due to the conductivity of a metallized surface, the material can function as a RF antenna. With a laser, metal can be removed from the package film, but leaving the base film intact, so that there are two electrically and physically isolated portions of metallic surface. A gap must be incorporated between the portions to provide electrical isolation. Another non-conductive substrate, such as a paper or polymer, could be laminated to the metallized film so that the packaging maintains two electrically isolated surfaces. An appropriate integrated circuit article preferably using an interposer will convert the package into an RFID device (or a similar device) if access to the portions of the metallized surface is available. The interposer can be applied to the package (RFID antenna) as described herein to replace the less versatile bar code. A separate substrate of the device that contains an antenna layer would not be required because the metallized film layer forming the antenna is a portion of the packaging film.

### Brief Description of the Drawings

FIGURE 1 shows a top view of an interposer-chip subassembly forming part of a radio frequency identifier (RFID) tag of the present invention positioned on a web containing a series of such subassemblies;
FIGURE 2 shows an interposer-chip subassembly across the gap of a thin metallic film of an antenna;
FIGURE 3 is an expanded perspective view of a liner, conductive adhesive, conductive ink, and label;
FIGURE 4 shows a label and conductive ink;
FIGURE 5 is a preferred pattern for the conductive ink;
FIGURE 6 shows a die and conductive ink;
FIGURE 7 is a preferred pattern for the conductive adhesive;
FIGURE 8 illustrates the conductive ink and adhesive;
Figure 9 shows an orientation of the interposer to a horizontal antenna or similar circuit;
Figure 10 shows an orientation of the interposer to a vertical antenna or similar circuit; and
Figure 11 shows a liner, conductive adhesive and conductive ink as an assembly step.

### Detailed Description of the Invention

A thin film circuit, shown as an antenna 20 (or a similar circuit made from metallized film or other metallized flex circuit) can be made from a thin etched or stamped foil, typically manufactured from a thin foil of copper, copper-alloy, or nickel-iron alloy by stamping or etching. The etching or stamping creates patterns on strips that become antennas. Other methods of making an antenna include printing a conductive ink. This invention relates to ICs 10, which are joined and electrically connected to individual antennas 20, focusing on the interposer 30, its substrate 32, and the printing of contact pads 34 and 36 thereon onto which the IC 10 is incorporated. The layer of anisotropically conductive pressure sensitive adhesive 38 makes contact with connectors of the IC 10 as to interconnect the antenna 20 and the IC 10. Pressure sensitive adhesives are selected for ease of application, but other adhesives are available though not necessarily preferred. Two different adhesives, both conductive, can be used in association with the interposer 30. A pressure sensitive conductive adhesive is preferred for attachment of the interposer 30 to the antenna 20 or similar circuit, and a different adhesive can be used to attach the IC 10 to the interposer 30, such as a conductive hot melt.

The subassembly includes IC 10 on the interposer 30 such that the IC 10 is in contact with both pads 34 and 36 of the interposer 30. The subassembly is adhered to a base circuit substrate to form a device. In a preferred embodiment, the subassembly is adhered to a thin metallic film antenna 20 to form an RFID.

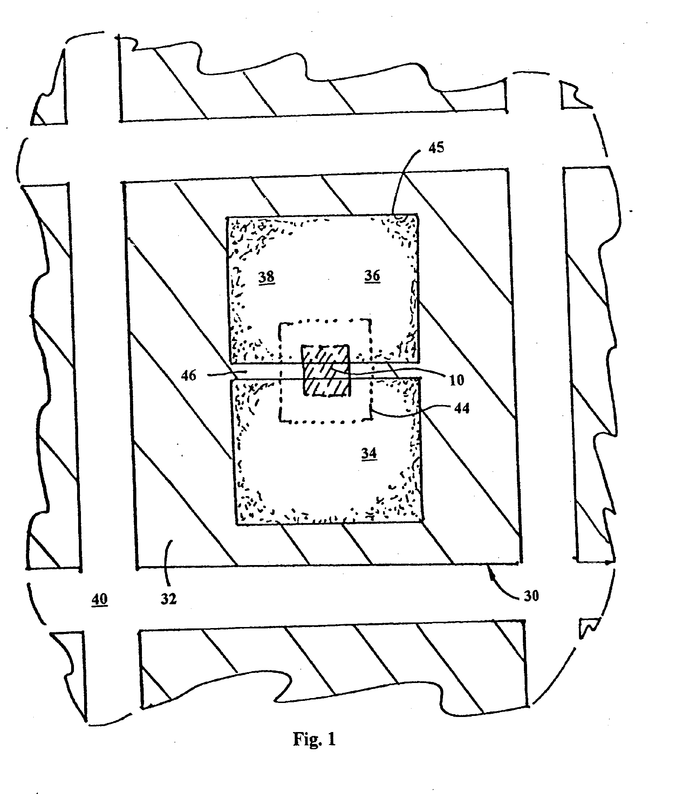

FIGURE 1 shows an interposer **30** having a substrate **32** (on a matrix web **40**) with an attached IC **10.** The interposer **30** is ideally as small as possible such as 10mm (0.400 inches) square, not including the matrix web portion (which is typically 1.52mm (0.060 inches) in length between each interposer). The interposer **30** preferably has a geometric shape, such as a rectangle or square, that allows for ease of insertion by a standard press head. An 0.45m (eighteen-inch) web can contain thirty-six interposers **30** across for use in mass production.

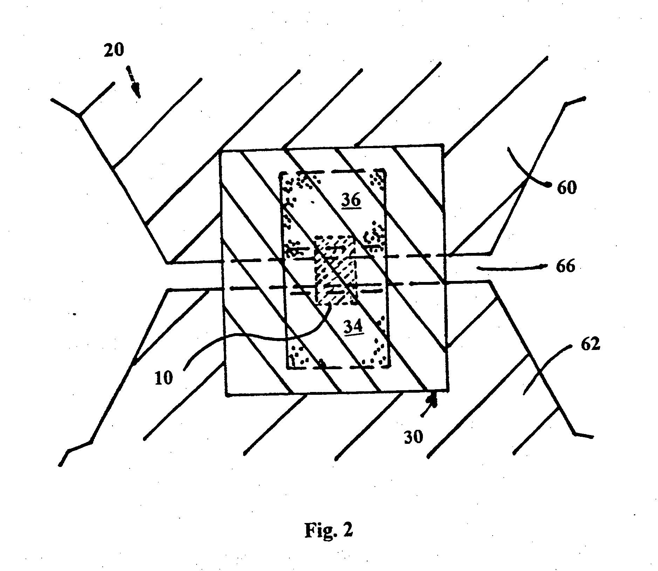

FIGURE 1 indicates a raised non-contact area **44** of the interposer **30** around the IC **10** resulting from the height of the IC **10.** The non-contact area **44** is created when the interposer **30** is applied across a gap **66** of a thin metallic film antenna **20,** as shown in FIGURE 2. This raised area **44** assumes a height of 0.15mm (0.006 inch) for the IC and a ten-degree contact angle.

The interposer substrate **32** can be a variety of film or paper. Flexible substrates, such a polymeric film or paper, are preferred. Ideally, the surface of the substrate **32** is ink-receptive if a carbon pad (**34** or **36**) or a similar pad is printed.

The pads **34** and **36** are conductive surfaces that are designed to make electrical contact with antenna portions **60** and **62.** Pads **34** and **36** provide a large effective electrical contact, which reduces the accuracy required for placement of ICs during manufacture while still providing effective electrical connection. As shown in FIGURE 1, the pads **34** and 36 would conduct only in a direction transverse to pads **34** and **36**. The pads **34** and **36** physically and electrically contact the antenna portions **60** and **62,** via conductive (preferably pressure sensitive) adhesive **38,** as shown in FIGURE **2****.** There is a gap **46** between the pads **34** and **36** so that they are electrically isolated surfaces. The gap **46** between the pads **34** and **36** is not as critical as the gap **66** between antenna portions **60** and **62,** which makes it easier to insert the IC **10** attached to an interposer **30.** As shown in FIGURE 1, the carbon ink area of the pads (**34** and **36**) is 0.25 square mm (0.04 square inches) (0.5mm x 0.5mm (0.2 by 0.2) inch for each pad).

Preferably, the pads **34** and **36** are silver or carbon printed. Known printing techniques such as flexographic, screen, or rotogravure are suitable. The preferable resistance is less than 100 ohms per square. (Resistivity is measured on a strip with a 10:1 length to width ratio. Ohm/square is determined by dividing the resistance measurement along the length by 10.) The choice of material depends on the costs and level of conductivity required. The lowest possible resistance is ideally preferred. Carbon is approximately 100 ohms per square compared to less than one ohm per square for silver, but silver is approximately ten times as expensive. Certain metallized films (i.e., vapor deposited) and foils have greater conductivity.

The leading edge **45** of the printed pad **36** can serve as an alignment mark in printing. As shown in FIGURE 1, leading edge **45** is 5.1mm (0.200 inch) in length. It does not extend the whole length of the substrate **32** and is representative of a printed carbon ink. The pads **34** and **36** may be smaller if a more conductive material such as silver is used. The carbon ink or silver ink pad need not be printed on the entire interposer surface.

A conductive adhesive film **38** secures the components of the device, such as an RFID tag. The conductive adhesive can be applied or printed over any conductor including metallized film, printed conductive inks (either carbon or silver or combinations thereof), foils or other conductors. Ideally, the same adhesive can be used to mount and hold the IC **10** that bonds the device together. A pressure sensitive anisotropically conductive adhesive is most desirable to mount the IC **10** to the interposer **30,** as well as to bond the resulting tag or device together. The conductive adhesive is preferably printable. The pressure sensitive adhesive film **38** will adhere the components together with an electrically conductive film that transmits current only anisotropically.

The conductive adhesive may also serve to hold the interposer **30** to a liner, which allows handling of interposers **30** in roll form to be applied as labels from reels. The adhesive properties of the conductive adhesive are adjusted with the liner to facilitate the handling of interposers during IC attachment and to provide release properties to allow mechanical insertion in high volume applications.

The pressure sensitive adhesive does not require the application of heat to adhere the components. The pressure sensitive adhesive can be cured through radiation (UV or EB) or can be conventionally dried (either as solvent-based or water-based). UV cured adhesives have been used as the preferred curing/drying method, and for high-speed production, a quick curing solution is required. H.B. Fuller has a part for such a formula, namely Solar Cure RT-7575. Ideally, the anisotropically conductive adhesive is a printable, UV-quick curable, pressure sensitive adhesive that maintains its flexibility. Adhesives to be avoided include those that require UV, heat or microwave curing that have an unacceptable cure time for high speed production. The pressure sensitive adhesive film 38 ideally has a minimal resistance, but metal or other conductors adversely affect the adhesion. The pressure sensitive adhesive film 38 must be suitable for high speed applications, such as having properties that avoid bubbling. The adhesive must provide sufficient bonding and electrical properties at a high speed insertion. It should preferably maintain flexibility without losing its connection.

The adhesive is preferably printed over the conductor area and serves to attach the interposer to the antenna halves, both physically and electrically. The adhesive can be printed either by flexographic, gravure or screen printing or other suitable printing methods.

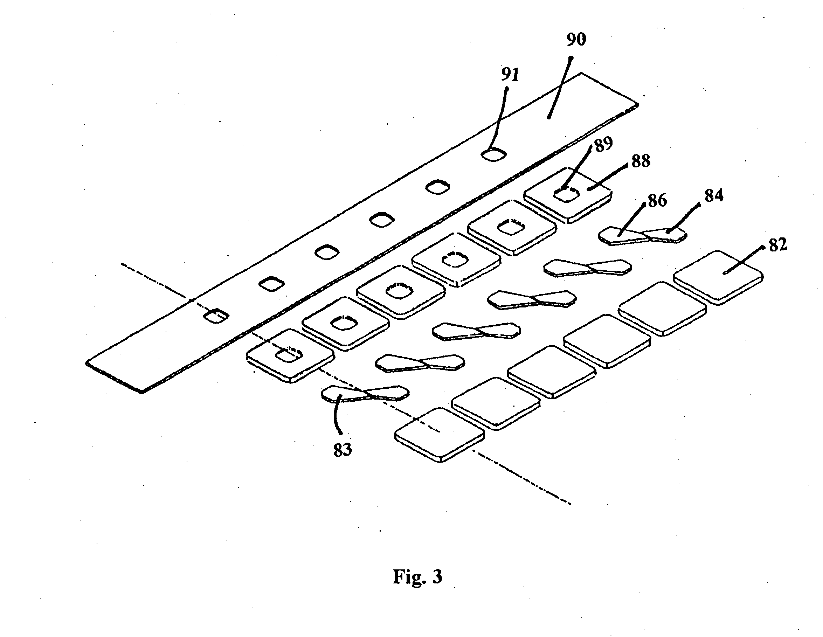

As shown in Figures 3 through 11, the preferred geometry allows universal orientation of the antenna or similar circuit to the web and allows efficient interposer insertion regardless of the orientation of the antenna or similar circuit. Figure 3 is an expanded perspective view of a label 82, conductive ink 83 with two pads 84 and 86, a conductive adhesive 88 with a recess 89, and liner 90 with an aperture 91.

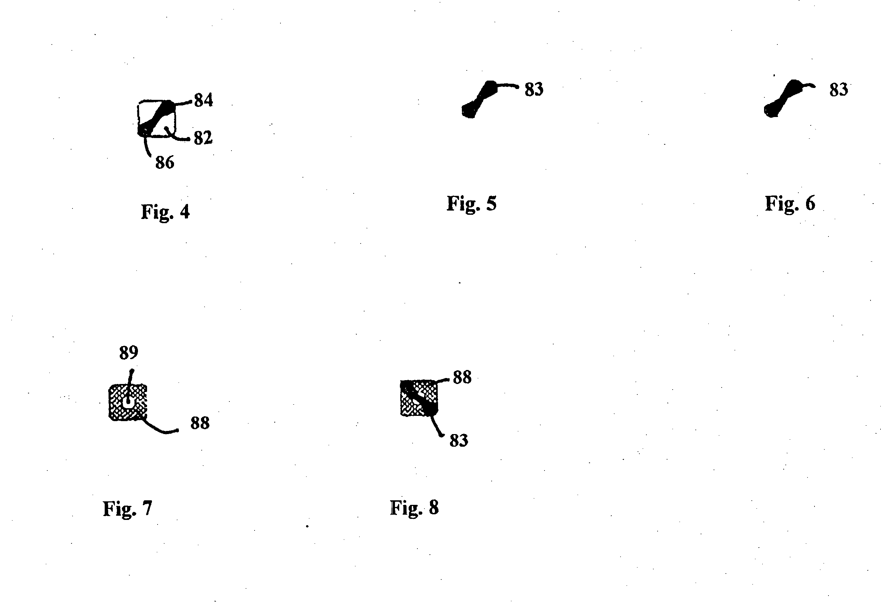

Figure 4 shows a label 82 and conductive ink pads 84 and 86 that are in the shape of a propeller, but may be shaped in a butterfly or bow-tie pattern, preferably with a separation line between each portion as can best be seen in Figure 3. The pattern has a gap or separation line that is perpendicular to the web to allow for IC placement across the gap. The butterfly, propeller, or bow-tie pattern preferably extends from one corner of the label 82 to the opposite corner. Figure 5 is a preferred pattern for the conductive ink 83, and Figure 6 shows a die and conductive ink 83.

Figure 7 is a preferred pattern for the conductive adhesive 88. Preferably, a conductive adhesive 88 is printed or applied around the edges of a label with a recess 89 of no adhesive in the center.

Figure 8 illustrates the conductive ink 83 and the conductive adhesive 88 as they relate to each other geometrically.

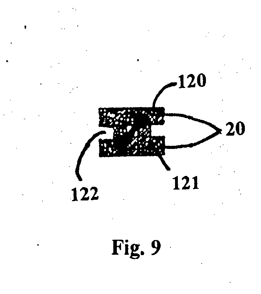

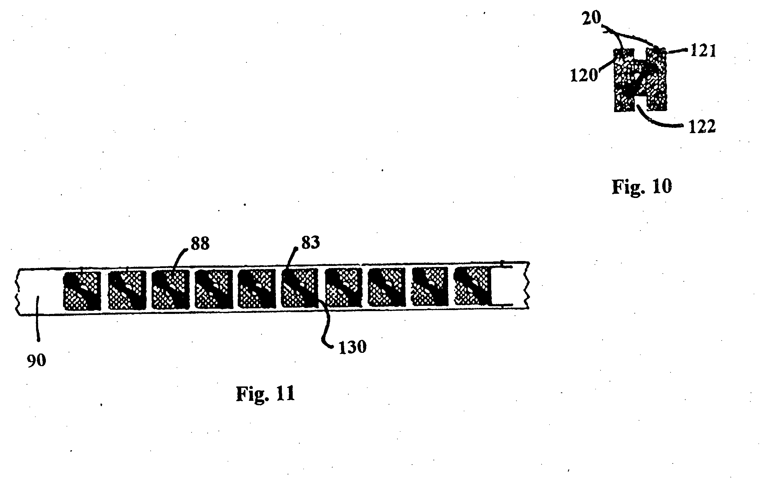

As can be best seen in Figures 9 and 10, the improved geometry allows universal orientation of the antenna portions 120 and 121 to the direction of the web and allows efficient interposer 30 insertion regardless of antenna 20 orientation. The geometry of components allows for attachment of the interposer chip subcomponent regardless of the orientation of the antenna 20 or similar circuit. The antenna gaps 122 may be oriented either parallel or perpendicular to the web direction during printing or insertion.

Figure 9 shows an orientation of a horizontal antenna 20 or similar circuit to the interposer 30, and Figure 10 shows an orientation of a vertical antenna 20 or similar circuit to the interposer 30.

Figure 11 shows a liner 90, conductive adhesive 88 and conductive ink 83 as an assembly step, which can be used as a reel. Figure 1 shows an interposer 30 on a matrix web 40. Different methods and label printing equipment require different configurations of the interposers 30. A leading edge or even a trailing edge of each component can serve as an eye mark 130 for signaling information to production or quality control equipment.

In a preferred method, the method of making a RF type device, without the application of heat, comprises the steps of:
1. providing a thin film substrate circuit, such as antenna portions formed from metallized film or other metallized flex circuit on a polymeric film;
2. forming an interposer 30 having two separate printed electrical contact pads 34 and 36, which are preferably printed in a butterfly, propeller, or bow-tie pattern with a separation line between each portion. A conductive adhesive can be applied or printed over any conductor including metallized film, printed conductive inks (either carbon or silver or combinations thereof), foils or other conductors.
3. placing an IC 10 on the interposer 30 such that the IC 10 is in contact with both pads 34 and 36 of the interposer 30 to form a subassembly;
4. locating the interposer-chip subassembly over a portion of the thin film substrate circuit, such as over the gap between two metallized portions of a thin metallic film antenna;
5. electrically connecting the IC to the thin film substrate circuit, such as by placing the interposer over the circuit, connecting it to each antenna portion, thereby securing the IC and at least a portion of the circuit; and
6. cutting the circuit substrate to form individual devices.

The method of applying the IC mounted on an interposer can be accomplished using a standard press head, which is existing technology for many convertors. Preferably, numerous interposer-chip subassemblies are prepared for subsequent attachment to circuits to form devices at high line speeds. Also, an additional step of detecting defects on the ICs on the interposers can be performed before applying the subassembly to the thin film circuit. If defects are found, the defective IC assembly will be skipped.

## Claims

1. A radio frequency identification (RFID) tag comprising:
a first substrate, with a first antenna element (60) and a second antenna element (62) disposed on the first substrate, wherein the first antenna element (60) is electrically isolated from the second antenna element (62);
**characterised by**:
a second substrate (32), with a first contact pad (34) and a second contact pad (36) disposed on the second substrate (32);
the first contact pad (34) being electrically isolated from the second contact pad (36); and
an integrated circuit (10) coupled to the first (34) and second (36) contact pads, wherein the first (34) and second (36) contact pads are in electrical contact with the first (60) and second (62) antenna elements.

2. The RFID tag according to claim 1, wherein the first (34) and second (36) contact pads form a shape of two oval, or triangular, or polygonal lobes positioned at or near their narrowest point to lie along a common vertical axis.

3. The RFID according to claim 1 or claim 2, wherein a conductive adhesive is applied to at least a portion of the first (34) and second (36) contact pads.

4. The RFID tag according to and of claims 1 to 3, wherein at least one of antenna element (60; 62), first contact pad (34) and second contact pad (36) is printed.

5. The RFID tag according to any of the preceding claims, wherein the circuit (10) is electrically coupled to the first (34) and second (36) contact pads.

6. The RFID tag according to any of the preceding claims, wherein the first contact pad (34) is disposed on the second substrate diagonally from the second contact pad.

7. The RFID tag according to any of the preceding claims, wherein the first (34) and second (36) contact pads are electrically isolated from each other.

8. The RFID tag according to any of the preceding claims, wherein the first (34) and second (36) contact pads are physically separated from each other.

9. The RFID tag according to any of the preceding claims, wherein at least one of the first (34) and second (36) contact pads is printed with a material selected from a group consisting of: carbon and a metalized material.

10. The RFID tag according to any of the preceding claims, wherein the antenna element is divided into a first half and a second half, and wherein the first contact pad is designed to make electrical contact with the first half of the antenna, and the second contact pad is designed to make electrical contact with the second half of the antenna.

11. A method of making a radio frequency identification (RFID) tag comprising the steps of:
providing a thin film substrate circuit on which a first antenna element (60) and a second antenna element (62) electrically isolated from each other are disposed;
forming an interposer having first (34) and second (36) contact pads electrically isolated from each other;
coupling an integrated circuit chip (10) to the first (34) and second (36) contact pads to form a subassembly;
locating the subassembly over a portion of the thin film substrate circuit; and
electrically connecting the integrated circuit chip (10) to the first antenna element (60) and second antenna element (62) by placing the subassembly in contact with the substrate circuit, thereby securing the integrated circuit chip to at least the portion of the substrate circuit.

12. The method of making the radio frequency device of claim 11 wherein the contact pads (34, 36) are formed in the shape of two oval, or triangular, or polygonal lobes positioned near their narrowest point to lie along a common vertical axis, with a gap between the pads.

13. The method of making the radio frequency device of claim 11 or claim 12, wherein the thin film substrate circuit includes metallized antenna halves formed on a polymeric film.

14. The method of making the radio frequency device according to any of claims 11 to 13, wherein the step of locating the interposer-chip subassembly over the portion of the thin film substrate circuit is over a separation gap between the metallized halves of a metallic film antenna.

15. The method of making the radio frequency device according to any of claims 11 to 14 wherein the step of electrically connecting the integrated circuit chip to the thin film substrate circuit includes the step of placing the interposer in contact with the substrate circuit by connecting the integrated circuit chip to each metallized antenna half.

16. The method of making the radio frequency device according to any of claims 11 to 15, wherein the step of electrically connecting the integrated circuit chip to the thin film substrate circuit by placing the interposer-chip subassembly in contact with the substrate circuit is performed, both physically and electrically, with a conductive pressure sensitive adhesive.

17. The method of making the radio frequency device according to any of claims 11 to 16, wherein the step of placing the integrated circuit chip on the interposer such that the integrated circuit chip is in contact with the pads of the interposer to form the subassembly is performed with a conductive pressure sensitive adhesive.

18. The method of making the radio frequency device according to any of claims 11 to 17, wherein the conductive pressure sensitive adhesive is an anistropically conductive adhesive.

19. The method of making the radio frequency device according to any of claims 11 to 18, further comprising curing the conductive adhesive through radiation.

20. The method of making the radio frequency device according to any of claims 11 to 19, wherein the curing the conductive adhesive is ultraviolet curing.

21. The method of making the radio frequency device according to any of claims 11 to 20, wherein the step of placing the integrated circuit chip on the interposer such that the integrated circuit chip is in contact with the pads of the interposer to form the subassembly and the step of electrically connecting the integrated circuit chip to the thin film substrate circuit by placing the interposer-chip subassembly in contact with the substrate circuit are both performed with the same anistropically conductive pressure sensitive adhesive.

22. The method of making the radio frequency device according to any of claims 11 to 21, including an additional step of detecting defects in the integrated circuit chip of the subassembly before applying the subassembly to the thin film substrate circuit.

23. The method of making the radio frequency device according to claim 22, including an additional step of isolating and skipping placement of the subassembly having the detected defect in contact with the thin film substrate circuit.

## Patentansprüche

1. Radiofrequenzidentifikationstransponder (RFID), umfassend:
ein erstes Substrat mit einem ersten Antennenelement (60) und einem zweiten Antennenelement (62), das auf dem ersten Substrat angeordnet ist, wobei das erste Antennenelement (60) elektrisch von dem zweiten Antennenelement (62) isoliert ist;
**dadurch gekennzeichnet, dass**
ein zweites Substrat (32) mit einer ersten Kontaktstelle (34) und einer zweiten Kontaktstelle (36), auf dem zweiten Substrat (32) angeordnet ist;
dass die erste Kontaktstelle (34) elektrisch von der zweiten Kontaktstelle (36) isoliert ist; und
ein integrierter Schaltkreis (10), der an die erste Kontaktstelle (34) und die zweite Kontaktstelle (36) angeschlossen ist,
wobei die erste Kontaktstelle (34) und zweite Kontaktstelle (36) in elektrischem Kontakt mit dem ersten Antennenelement (60) und dem zweiten Antennenelement (62) steht.

2. RFID-Transponder nach Anspruch 1, wobei die erste (34) und die zweite (36) Kontaktstelle die Form zweier ovaler, dreieckiger, oder polygonaler Lappen, die an oder in der Nähe ihres engsten Punktes angeordnet sind, bilden, um auf einer gemeinsamen vertikalen Achse zu liegen.

3. RFID-Transponder nach Anspruch 1 oder 2, wobei ein leitendes Haftmittel zumindest auf einen Teil der ersten Kontaktstelle (34) und der zweiten Kontaktstelle (34) aufgebracht ist.

4. RFID-Transponder nach einem der Ansprüche 1 bis 3, wobei zumindest eines von den Antennenelementen (60; 62), der ersten Kontaktstelle (34) und der zweite Kontaktstelle (36) gedruckt ist.

5. RFID-Transponder nach einem der vorangehenden Ansprüche, wobei der Schaltkreis (10) elektrisch an die erste Kontaktstelle (34) und zweite Kontaktstelle (36) angebunden ist.

6. RFID-Transponder nach einem der vorangehenden Ansprüche, wobei die erste Kontaktstelle (34) auf dem zweiten Substrat diagonal zu der zweiten Kontaktstelle angeordnet ist.

7. RFID-Transponder nach einem der vorangehenden Ansprüche, wobei die erste Kontaktstelle (34) und die zweite Kontaktstelle (36) voneinander elektrisch isoliert sind.

8. RFID-Transponder nach einem der vorangehenden Ansprüche, wobei die erste Kontaktstelle (34) und die zweite Kontaktstelle (36) physikalisch voneinander getrennt sind.

9. RFID-Transponder nach einem der vorangehenden Ansprüche, wobei zumindest eines von der ersten Kontaktstelle (34) und der zweiten Kontaktstelle (36) mit einem Material ausgesucht aus einer Gruppe umfassend Kohlenstoff und einem metallenen Material, gedruckt ist.

10. RFID-Transponder nach einem der vorangehenden Ansprüche, wobei das Antennenelement in eine erste Hälfte und eine zweite Hälfte geteilt ist, und wobei die erste Kontaktstelle ausgebildet ist, um elektrischen Kontakt mit der ersten Hälfte der Antenne herzustellen, und wobei die zweite Kontaktstelle ausgebildet ist, um elektrischen Kontakt mit der zweiten Hälfte der Antenne herzustellen.

11. Verfahren zur Herstellung eines Radiofrequenzidentifikationstransponders (RFID), umfassend die Schritte:
Bereitstellen eines Dünnfilmsubstratschaltkreises, auf dem ein erstes Antennenelement (60) und ein zweites Antennenelement (62) elektrisch voneinander isoliert angeordnet sind;
Ausbilden eines Interposers mit einer ersten Kontaktstelle (34) und einer zweiten Kontaktstelle (36), die elektrisch voneinander isoliert sind;
Verbinden eines integrierten Schaltkreischips (10) mit der ersten Kontaktstelle (34) und der zweiten Kontaktstelle (36), um eine Untergruppe zu bilden;
Anordnen der Untergruppe über einen Teil des Dünnfilmsubstratschaltkreises; und
elektrisches Verbinden des integrierten Schaltkreischips (10) mit dem ersten Antennenelement (60) und dem zweiten Antennenelement (62) durch Platzieren der Untergruppe in Kontakt mit dem Substratschaltkreis, wodurch der integrierte Schaltkreischip an zumindest einem Teil des Substratschaltkreises befestigt wird.

12. Verfahren zur Herstellung des Radiofrequenzgeräts nach Anspruch 11, wobei die Kontaktstellen (34, 36) in der Gestalt zweier ovaler, dreieckiger, oder polygonaler Lappen ausgebildet sind, die nahe ihrer engsten Stelle angeordnet sind, um entlang einer gemeinsamen vertikalen Achse zu liegen, mit einer Lücke zwischen den Kontaktstellen.

13. Verfahren zu Herstellung des Radiofrequenzgeräts nach Anspruch 11 oder 12, wobei der Dünnfilmsubstratschaltkreis metallene Antennenhälften, ausgebildet auf einem polymeren Film, umfasst.

14. Verfahren zur Herstellung des Radiofrequenzgeräts nach einem der Ansprüche 11 bis 13, wobei der Schritt des Anordnens der Interposerchipuntergruppe über dem Teil des Dünnfoliensubstratschaltkreises über einer Trennlücke zwischen den metallenen Hälften einer metallenen Filmantenne stattfindet.

15. Verfahren zur Herstellung des Radiofrequenzgeräts nach einem der Ansprüche 11 bis 14, wobei der Schritt des elektrischen Verbindens des integrierten Schaltkreises mit dem Dünnfilmsubstratschaltkreis den Schritt des Platzierens des Interposers in Kontakt mit dem Substratschaltkreis durch Verbinden des integrierten Schaltkreischips mit jeder der metallenen Antennenhälften umfasst.

16. Verfahren zur Herstellung des Radiofrequenzgeräts nach einem der Ansprüche 11 bis 15, wobei der Schritt des elektrischen Verbindens des integrierten Schaltkreischips mit dem Dünnfilmsubstratschaltkreises durch Platzieren der Interposerchipuntergruppe in Kontakt mit dem Substratschaltkreis physisch und elektrisch mit einem leitenden drucksensitiven Klebemittel erfolgt.

17. Verfahren zur Herstellung des Radiofrequenzgerätes nach einem der Ansprüche 11 bis 16, wobei der Schritt des Platzierens des integrierten Schaltkreischips auf dem Interposer mit einem leitenden drucksensitiven Klebstoff ausgeführt wird, so dass der integrierte Schaltkreischip in Kontakt mit den Kontaktstellen des Interposers ist, um die Untergruppe zu bilden.

18. Verfahren zur Herstellung des Radiofrequenzgeräts nach einem der Ansprüche 11 bis 17, wobei der elektrisch leitende drucksensitive Klebstoff ein anisotropisch elektrisch leitender Klebstoff ist.

19. Verfahren zu Herstellung des Radiofrequenzgeräts nach einem der Ansprüche 11 bis 18, ferner umfassend Härten des elektrisch leitenden Klebstoffs durch Strahlung.

20. Verfahren zur Herstellung des Radiofrequenzgeräts nach einem der Ansprüche 11 bis 19, wobei das Härten des elektrisch leitenden Klebstoffs ein ultraviolettes Härten ist.

21. Verfahren zu Herstellung des Radiofrequenzgeräts nach einem der Ansprüche 11 bis 20, wobei der Schritt des Platzierens des integrierten Schaltkreischips auf dem Interposer, so dass der integrierte Schaltkreischips in Kontakt mit den Kontaktstellen der Verdrahtungslage, um eine Untergruppe zu bilden, und der Schritt des elektrischen Verbindens des integrierten Schaltkreischips mit dem Dünnfilmsubstratschaltkreis durch Platzieren der Interposerchipuntergruppe in Kontakt mit dem Substratschaltkreis, beide mit demselben anisotropisch leitenden drucksensitiven Klebstoff ausgeführt werden.

22. Verfahren zur Herstellung des Radiofrequenzgeräts nach einem der Ansprüche 11 bis 21, umfassend den zusätzlichen Schritt Detektieren von Defekten in dem integrierten Schaltkreischip der Untergruppe vor Aufbringung der Untergruppe auf dem Dünnfilmsubstratschaltkreis.

23. Verfahren zur Herstellung des Radiofrequenzgeräts nach Anspruch 22, umfassend einen zusätzlichen Schritt des Isolierens und Platzierens einer Überbrückung der Untergruppe mit einem erkannten Defekt in Kontakt mit dem Dünnfilmsubstratschaltkreis.

## Revendications

1. Etiquette d'identification par radiofréquence (RFID) comprenant :
un premier substrat, avec un premier élément d'antenne (60) et un second élément d'antenne (62) disposés sur le premier substrat, où le premier élément d'antenne (60) est isolé électriquement du second élément d'antenne (62) ;
**caractérisée par** :
un second substrat (32), avec une première plage de contact (34) et une seconde plage de contact (36) disposées sur le second substrat (32) ;
la première plage de contact (34) étant isolée électriquement de la seconde plage de contact (36) ; et
un circuit intégré (10) couplé aux première (34) et seconde (36) plages de contact, où les première (34) et seconde (36) plages de contact sont en contact électrique avec les premier (60) et second (62) éléments d'antenne.

2. Etiquette RFID selon la revendication 1, dans laquelle les première (34) et seconde (36) plages de contact forment une forme de deux lobes ovales, ou triangulaires, ou polygonaux positionnés au niveau de ou près de leur point le plus étroit pour s'étendre le long d'un axe vertical commun.

3. Etiquette RFID selon la revendication 1 ou la revendication 2, dans laquelle un adhésif conducteur est appliqué à au moins une partie des première (34) et seconde (36) plages de contact.

4. Etiquette RFID selon l'une quelconque des revendications 1 à 3, dans laquelle au moins un de l'élément d'antenne (60 ; 62), de la première plage de contact (34) et de la seconde plage de contact (36) est imprimé.

5. Etiquette RFID selon l'une quelconque des revendications précédentes, dans laquelle le circuit (10) est couplé électriquement aux première (34) et seconde (36) plages de contact.

6. Etiquette RFID selon l'une quelconque des revendications précédentes, dans laquelle la première plage de contact (34) est disposée sur le second substrat en diagonale par rapport à la seconde plage de contact.

7. Etiquette RFID selon l'une quelconque des revendications précédentes, dans laquelle les première (34) et seconde (36) plages de contact sont isolées électriquement l'une de l'autre.

8. Etiquette RFID selon l'une quelconque des revendications précédentes, dans laquelle les première (34) et seconde (36) plages de contact sont séparées physiquement l'une de l'autre.

9. Etiquette RFID selon l'une quelconque des revendications précédentes, dans laquelle au moins une des première (34) et seconde (36) plages de contact est imprimée avec un matériau sélectionné dans un groupe comprenant : le carbone et un matériau métallisé.

10. Etiquette RFID selon l'une quelconque des revendications précédentes, dans laquelle l'élément d'antenne est divisé en une première moitié et une seconde moitié, et dans laquelle la première plage de contact est conçue pour effectuer un contact électrique avec la première moitié de l'antenne, et la seconde plage de contact est conçue pour effectuer un contact électrique avec la seconde moitié de l'antenne.

11. Procédé de fabrication d'une étiquette d'identification par radiofréquence (RFID), comprenant les étapes consistant à :
fournir un circuit de substrat à film mince sur lequel un premier élément d'antenne (60) et un second élément d'antenne (62) isolés électriquement l'un de l'autre sont disposés ;
former un interposeur ayant des première (34) et seconde (36) plages de contact isolées électriquement l'une de l'autre ;
coupler une puce de circuit intégré (10) aux première (34) et seconde (36) plages de contact pour former un sous-ensemble ;
localiser le sous-ensemble sur une partie du circuit de substrat à film mince ; et
connecter électriquement la puce de circuit intégré (10) au premier élément d'antenne (60) et au second élément d'antenne (62) en plaçant le sous-ensemble en contact avec le circuit de substrat, fixant ainsi la puce de circuit intégré à au moins la partie du circuit de substrat.

12. Procédé de fabrication du dispositif radiofréquence selon la revendication 11, dans lequel les plages de contact (34, 36) sont formées en forme de deux lobes ovales, ou triangulaires, ou polygonaux positionnés près de leur point le plus étroit pour s'étendre le long d'un axe vertical commun, avec un espace entre les plages.

13. Procédé de fabrication du dispositif radiofréquence selon la revendication 11 ou la revendication 12, dans lequel le circuit de substrat à film mince comprend des moitiés d'antenne métallisées formées sur un film polymère.

14. Procédé de fabrication du dispositif radiofréquence selon l'une quelconque des revendications 11 à 13, dans lequel l'étape consistant à localiser le sous-ensemble interposeur-puce sur la partie du circuit de substrat à film mince est sur un espace de séparation entre les moitiés métallisées d'une antenne à film métallique.

15. Procédé de fabrication du dispositif radiofréquence selon l'une quelconque des revendications 11 à 14, dans lequel l'étape consistant à connecter électriquement la puce de circuit intégré au circuit de substrat à film mince comprend l'étape consistant à placer l'interposeur en contact avec le circuit de substrat en connectant la puce de circuit intégré à chaque moitié d'antenne métallisée.

16. Procédé de fabrication du dispositif radiofréquence selon l'une quelconque des revendications 11 à 15, dans lequel l'étape consistant à connecter électriquement la puce de circuit intégré au circuit de substrat à film mince en plaçant le sous-ensemble interposeur-puce en contact avec le circuit de substrat est effectuée, à la fois physiquement et électriquement, avec un adhésif sensible à la pression conducteur.

17. Procédé de fabrication du dispositif radiofréquence selon l'une quelconque des revendications 11 à 16, dans lequel l'étape consistant à placer la puce de circuit intégré sur l'interposeur de sorte que la puce de circuit intégré soit en contact avec les plages de l'interposeur pour former le sous-ensemble est effectuée avec un adhésif sensible à la pression conducteur.

18. Procédé de fabrication du dispositif radiofréquence selon l'une quelconque des revendications 11 à 17, dans lequel l'adhésif sensible à la pression conducteur est un adhésif anisotropiquement conducteur.

19. Procédé de fabrication du dispositif radiofréquence selon l'une quelconque des revendications 11 à 18, comprenant en outre le séchage de l'adhésif conducteur par rayonnement.

20. Procédé de fabrication du dispositif radiofréquence selon l'une quelconque des revendications 11 à 19, dans lequel le séchage de l'adhésif conducteur est un séchage ultraviolet.

21. Procédé de fabrication du dispositif radiofréquence selon l'une quelconque des revendications 11 à 20, dans lequel l'étape consistant à placer la puce de circuit intégré sur l'interposeur de sorte que la puce de circuit intégré soit en contact avec les plages de l'interposeur pour former le sous-ensemble et l'étape consistant à connecter électriquement la puce de circuit intégré au circuit de substrat à film mince en plaçant le sous-ensemble interposeur-puce en contact avec le circuit de substrat sont toutes deux effectuées avec le même adhésif sensible à la pression anisotropiquement conducteur.

22. Procédé de fabrication du dispositif radiofréquence selon l'une quelconque des revendications 11 à 21, comprenant une étape additionnelle consistant à détecter des défauts dans la puce de circuit intégré du sous-ensemble avant d'appliquer le sous-ensemble au circuit de substrat à film mince.

23. Procédé de fabrication du dispositif radiofréquence selon la revendication 22, comprenant une étape additionnelle consistant à isoler et sauter le placement du sous-ensemble ayant le défaut détecté en contact avec le circuit de substrat à film mince.
